# EUROPEAN PATENT APPLICATION

(11) **EP 1 465 265 A2**
(43) Date of publication of application: **06.10.2004**
(21) Application number: 04007668.9
(22) Date of filing: 30.03.2004
(51) Int. Cl.: H01L 51/20, H01L 51/40, H01L 33/00

(54) **Area light emitting device, method for manufacturing area light emitting device, and optical device**

(30) Priority: 31.03.2003 JP 2003094216
(71) Applicant: Kabushiki Kaisha Toyota Jidoshokki, Kariya-shi, Aichi-ken (JP)
(72) Inventor: Utsumi, Tetsuya, Kariya-shi Aichi-ken (JP); Kato, Yoshifumi, Kariya-shi Aichi-ken (JP)
(74) Representative: Leson, Thomas Johannes Alois, Dipl.-Ing.

(57) **Abstract**

An area light emitting device includes a transparent or translucent substrate and an area light emitting element arranged on the substrate. The substrate includes a first surface facing the area light emitting element and a second surface facing away from the area light emitting element. The area light emitting element emits light that enters the first surface and exits from the second surface. The second surface includes a recess for accommodating an optical member that changes the characteristics of the light emitted from the area light emitting element.

## Description

### BACKGROUND OF THE INVENTION

The present invention relates to an area light emitting device, a method for manufacturing the area light emitting device, and an optical device, such as a liquid crystal display or a lighting device, incorporating the area light emitting device.

A bottom-emission type area light emitting device includes an area light emitting element, such as an organic electroluminescence (EL) element or an inorganic EL element that is provided on a transparent substrate to emit light from a certain area. The light emitted from the area light emitting element enters a light incidence surface, which is a surface of the transparent substrate facing the area light emitting element, and subsequently exits from a light exit surface, which is a surface of the transparent substrate facing away from the area light emitting element.

An optical member, such as a diffusion film, a prism film, or a liquid crystal panel, is arranged on the light exit surface of the transparent substrate to form an optical device, such as a liquid crystal display or a lighting device, with the area light emitting device. The optical member appropriately changes the characteristics of the light emitted from the area light emitting element, such as orientation, luminance, and chromaticity of the light. In other words, the optical member changes the light emitted from the area light emitting device qualitatively or quantitatively.

The diffusion film diffuses the light emitted from the area light emitting element so that the luminance of the light exiting from the diffusion film in any direction is substantially the same (refer to, for example, Japanese Laid-Open Patent Publication 2000-323272). The liquid crystal panel allows or inhibits the transmission of the light that is emitted from the area light emitting element in each pixel in accordance with the orientation of the liquid crystal, which changes in accordance with the applied voltage. This displays an image with the light emitted from the area light emitting element (refer to, for example, Japanese Laid-Open Patent Publication 10-253959).

The optical device is formed by superimposing the area light emitting device on the optical member. Thus, the thickness of the optical device must be greater than or equal to the sum of the thickness of the area light emitting device and the thickness of the optical member, and that makes it difficult to make the optical device thinner. Furthermore, a skilled person or a tool, such as a positioning frame, is necessary to properly position the optical member on the area light emitting device when attaching the area light emitting device and the optical member to each other.

### SUMMARY OF THE INVENTION

It is an object of the present invention to provide an area light emitting device that enables proper and facilitated positioning of an optical member during assembly while decreasing thickness of the area light emitting device when the optical member is attached. A further object of the present invention is to provide a method for manufacturing such an area light emitting device and to provide an optical device incorporating such an area light emitting device.

To achieve the above object, the present invention provides an area light emitting device for use with an optical member. The area light emitting device includes a transparent or translucent substrate and an area light emitting element arranged on the substrate. The substrate includes a first surface facing the area light emitting element and a second surface facing away from the area light emitting element. The area light emitting element emits light that enters the first surface and exits from the second surface. The second surface includes a recess for accommodating the optical member in which the optical member changes the characteristics of light emitted from the area light emitting element.

A further aspect of the present invention is a method for manufacturing an area light emitting device including a transparent or translucent substrate and an area light emitting element arranged on the transparent substrate for use with an optical member. The method includes preparing the substrate to include a first surface and a second surface, with the first surface and the second surface being located on opposite sides of the substrate. The method further includes forming the area light emitting element on the first surface of the substrate. The area light emitting element emits light that enters the first surface and exits from the second surface. The method also includes forming a recess in the second surface of the substrate after said forming of the area light emitting element. The recess is capable of accommodating the optical member in which the optical member changes the characteristics of light emitted from the area light emitting element.

### BRIEF DESCRIPTION OF THE DRAWINGS

The invention, together with objects and advantages thereof, may best be understood by reference to the following description of the presently preferred embodiment together with the accompanying drawings in which:
Fig. 1 is a perspective view showing a liquid crystal display according to a preferred embodiment of the present invention;
Fig. 2 is a cross sectional view of the liquid crystal display shown in Fig. 1;
Fig. 3(a) is a cross sectional view of the liquid crystal display shown in Fig. 1;
Fig. 3(b) is a cross sectional view showing a prior art liquid crystal display;
Fig. 4(a) is a cross sectional view of the liquid crystal display shown in Fig. 1;
Fig. 4(b) is a cross sectional view of a prior art liquid crystal display;
Fig. 5 is a flowchart illustrating a manufacturing process for the liquid crystal display shown in Fig. 1;
Fig. 6 is a cross sectional view of a lighting device according to another embodiment of the present invention;
Figs. 7, 8(a), and 8(b) are cross sectional views of a liquid crystal device according to a further embodiment of the present invention;
Figs. 9(a) to 9(c) are perspective views showing variants of a transparent substrate;
Fig. 10 is a flowchart illustrating another manufacturing process for the liquid crystal display shown in Fig. 1; and
Fig. 11 is a cross sectional view of a liquid crystal device according to a further embodiment of the present invention.

### DETAILED DESCRIPTION OF THE PREFERRED EMBODIMENTS

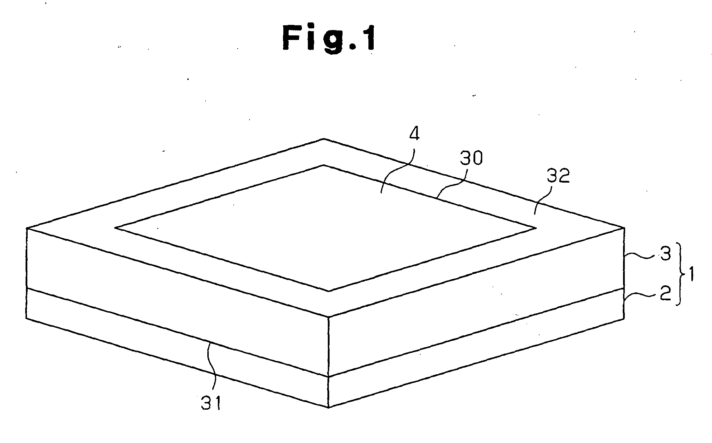

A preferred embodiment of the present invention will now be described with reference to Figs. 1 to 5. In Figs. 1 to 11, same numerals are used for same or similar elements throughout.

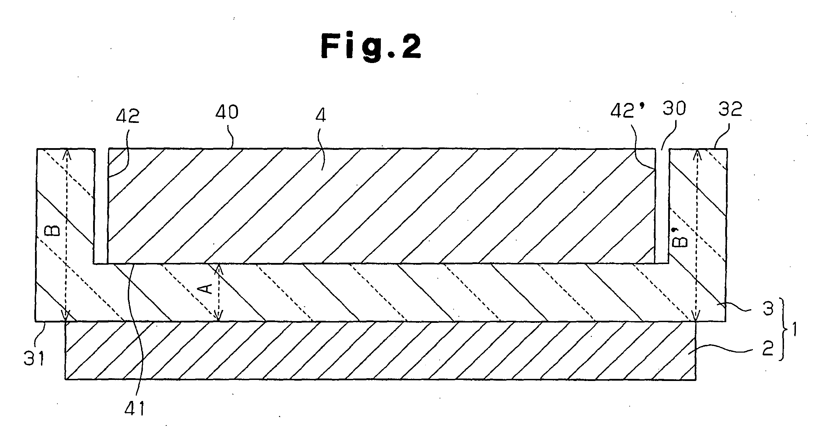

An optical device is embodied in a liquid crystal device in a first preferred embodiment of the present invention. As shown in Fig. 1 and Fig. 2, the liquid crystal device includes an organic EL device 1, which functions as an area light emitting device, and a liquid crystal panel 4, which functions as an optical member. The organic EL device 1 includes an organic EL element 2, which functions as an area light emitting element, and a transparent substrate 3.

The organic EL element 2 is arranged on and supported by the transparent substrate 3. The transparent substrate 3 has a light incidence surface 31, which is defined on the surface facing the organic EL element 2 and which receives the light emitted from the organic EL element 2. The transparent substrate 3 has a light exit surface 32, which is defined on the surface facing away frbm the organic EL element 2.

A recess 30 is formed in the central portion of the light exit surface 32 to install the entire liquid crystal panel 4. Therefore, as shown in Fig.2, the thickness A at the central portion of the transparent substrate 3 is less than the thicknesses B and B' at the rim of the transparent substrate 3.

The transparent substrate 3 is either transparent or translucent and transmits the light emitted from the organic EL element 2. The transparent substrate 3 preferably transmits more than 50% of the visible light (light having a wavelength of 380 to 800nm) emitted from the organic EL element 2. In other words, the light transmissivity is preferably 50% or more. The transparent substrate 3 is made of, for example, glass, quartz, or plastic. The transparent substrate 3 may be formed by combining a plurality of the same kind or different kinds of members.

The organic EL element 2, which has a known configuration, includes a light emitting layer containing an organic material having an electroluminescence property. The light emitting layer lies between an anode and a cathode of the organic EL element 2.

The entire liquid crystal panel 4 is placed within the recess 30 formed in the transparent substrate 3. The liquid crystal panel 4, which has a known configuration, is a transmissive panel using the organic EL element 2 as a light source or a semi-transmissive panel using both external light and the organic EL element 2 as the light source. The liquid crystal panel 4 has a display surface 40 defined on the surface facing away from the organic EL element 2. Further, the liquid crystal panel 4 generates an image on the display surface 40 using the light emitted from the organic EL element 2 or the external light. The liquid crystal panel 4 has a non-display surface 41 defined on the surface facing the organic EL element 2.

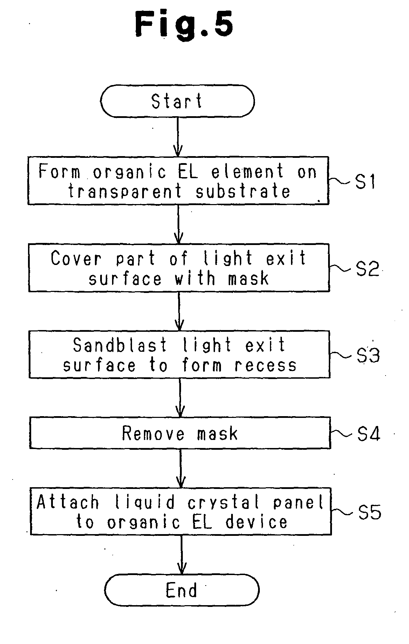

A process for manufacturing the liquid crystal display will now be explained with reference to Fig. 5.

In step S1, the transparent substrate 3 having thickness B is prepared, and the organic EL element 2 is formed thereon. In the following step S2, the surface of the transparent substrate 3 facing away from the organic EL element 2 or the light exit surface 32 is covered, except for the part where the recess 30 is to be formed, with a mask. In step S3, the light exit surface 32 is subjected to sandblasting in a state partially covered by the mask to grind the portion of the light exit surface 32 exposed from the mask. This forms the recess 30 in the portion of the light exit surface 32 that is exposed from the mask. In the following step S4, the mask is removed to complete the organic EL device 1. In step S5, the liquid crystal panel 4 is attached to the organic EL device 1 so that the liquid crystal panel 4 is installed in the recess 30. The liquid crystal display of the present embodiment is manufactured through the above procedures.

The present embodiment has the following advantages.

During manufacturing of the liquid crystal display, the liquid crystal panel 4 is attached to the organic EL device 1 at a predetermined position so long as the liquid crystal panel 4 is installed in the recess 30 of the transparent substrate 3. Therefore, with the organic EL device 1 of the present embodiment, the liquid crystal panel 4 is properly and easily positioned and attached to the organic EL device 1 without the need for a skilled person or a tool, such as a positioning frame.

The liquid crystal panel 4 is attached to the organic EL device 1 in a state accommodated in the recess 30. This prevents the liquid crystal panel 4 from departing away from the designed position.

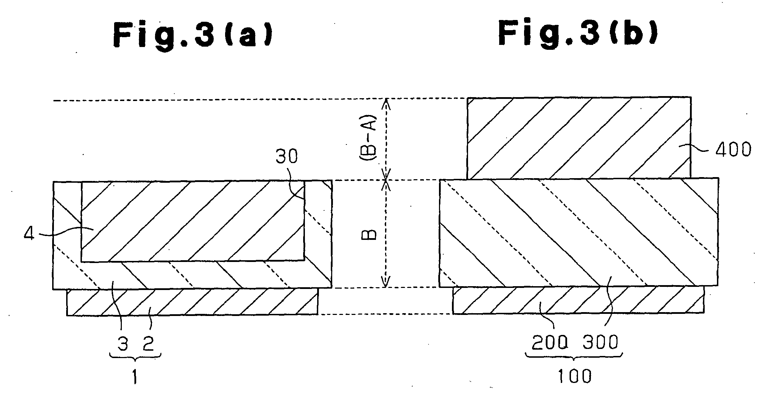

When comparing the liquid crystal display of the present embodiment shown in Fig. 3(a) and a conventional liquid crystal display shown in Fig. 3(b), the liquid crystal display of Fig. 3(a) is apparently thinner. The liquid crystal display shown in Fig. 3(b) differs from the liquid crystal display shown in Fig. 3(a) in that a transparent substrate 300 does not include a recess. The thickness B of the transparent substrate 300 is the same as that of only the rim of the transparent substrate 3. However, the thickness of the liquid crystal display shown in Fig. 3(b) is the sum of the thickness of an organic EL element 200, the thickness of the transparent substrate 300, and the thickness of a liquid crystal panel 400. In comparison, the thickness of the liquid crystal display shown in Fig. 3(a) is the sum of only the thickness of the organic EL element 2 and the thickness of the transparent substrate 3 since the liquid crystal panel 4 is accommodated in the recess 30 of the transparent substrate 3. Furthermore, the liquid crystal display shown in Fig. 3(a) is lighter than the liquid crystal display shown in Fig. 3(b) by the weight of the portion removed to form the recess 30. Accordingly, the organic EL device 1 of the liquid crystal display shown in Fig. 3(a) is lighter than the organic EL device 100 of the liquid crystal display shown in Fig. 3(b) by the weight of the portion removed to form the recess 30. Furthermore, since the liquid crystal display shown in Fig. 3(a) does not require a positioning frame, the liquid crystal display is thinner and lighter by the thickness and weight of the frame.

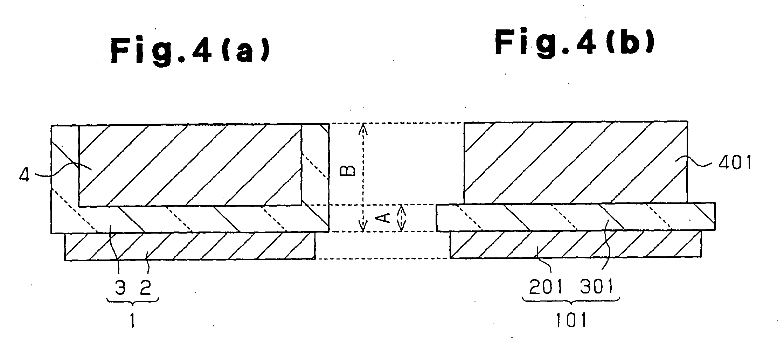

The transparent substrate 3 in the liquid crystal display of the present embodiment shown in Fig. 4(a) has a more strength than a transparent substrate 301 of the conventional liquid crystal display shown in Fig. 4(b) because of the rim with the thickness B. Thus, the liquid crystal display shown in Fig. 4(a) has a more strength than the liquid crystal display shown in Fig. 4(b), and the organic EL device 1 of the liquid crystal display shown in Fig. 4(a) has a more strength than an organic EL device 101 of the liquid crystal display shown in Fig. 4(b). The liquid crystal display shown in Fig. 4(b) differs from the liquid crystal display shown in Fig. 4(a) in that the transparent substrate 301 is not provided with a recess. Although the thickness A of the transparent substrate 301 is the same as that of only the central portion of the transparent substrate 3, the total thickness of the liquid crystal display shown in Fig. 4(a) and that shown in Fig. 4(b) are the same.

As shown in Fig. 2, the edges 42 and 42' of the liquid crystal panel 4 is surrounded by the rim of the transparent substrate 3 and thus is seldom subjected to external impact or erosion. Conversely, the conventional liquid crystal panels 400 and 401 shown in Figs. 3(b) and Fig. 4(b) are relatively vulnerable to external impact or erosion. Thus, a protector for protecting the end faces of the liquid crystal panel 400 and 401 must be separately provided in order to prevent such external impact or erosion.

The organic EL element 2 is formed on the transparent substrate 3 prior to the formation of the recess 30. Compared to a state in which the transparent substrate 3 has the recess 30, the transparent substrate 3 has more strength when there is no recess 30. Thus, the transparent substrate 3 is not easily bent when the organic EL element 2 is being formed on the transparent substrate 3. If the transparent substrate 3 bends during the formation of the organic EL element 2, the organic EL element 2 may have an uneven thickness. This may result in variance of luminance or short-circuiting of the electrode of the organic EL element 2 and thus decrease the yield.

The recess 30 is formed by performing sandblasting. Thus, the bottom surface of the recess 30 has an arithmetic mean roughness Ra of about 0.01 to 10µm and diffuses the light exiting from the bottom surface. Thus, the light exiting from the bottom surface of the recess 30 has a substantially uniform luminance irrespective of the direction of the exiting light. Therefore, in many cases, there is no need to provide a diffusion film between the transparent substrate 3 and the liquid crystal panel 4 to diffuse the light emitted from the organic EL element 2. This also decreases the weight and thickness of the liquid crystal display.

Light enters the bottom surface of the recess 30 from the rear side. More light is transmitted through the rough bottom surface in comparison to when the bottom surface is smooth. In other words, at least part of the light that does not exit the light exit surface 32 when the bottom surface of the recess 30 is smooth exits from the light exit surface 32 when the bottom surface is rough. This may be because, when compared to a smooth surface, a rough surface is more likely to transmit the incident light than to totally reflect. In general, the light is totally reflected at the interface if the angle of incidence is greater than the critical angle.

The luminance of the light exiting from the bottom surface of the recess 30 does not depend on the direction of the exit irrespective of the wavelength of the light. In other words, the chromaticity of the light exiting from the bottom surface of the recess 30 does not depend on the direction of the exiting light. This may also be due to the bottom surface of the recess 30 diffusing the light exiting from the bottom surface.

The present embodiment may be modified as described below.

The organic EL element 2 may be replaced by another type of area light emitting element, such as an inorganic EL element.

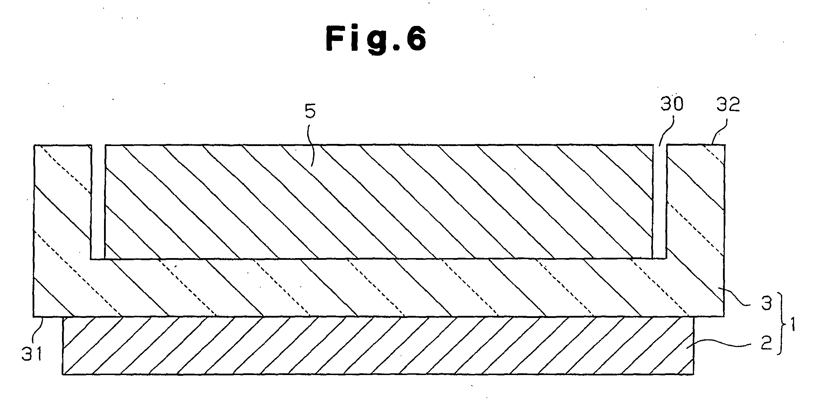

The liquid crystal panel 4 may be replaced by another type of optical member, such as a prism sheet or a diffusion sheet. For example, as shown in Fig. 6, in a lighting device, a prism sheet 5 may be attached to the organic EL 1 device in place of the liquid crystal panel 4.

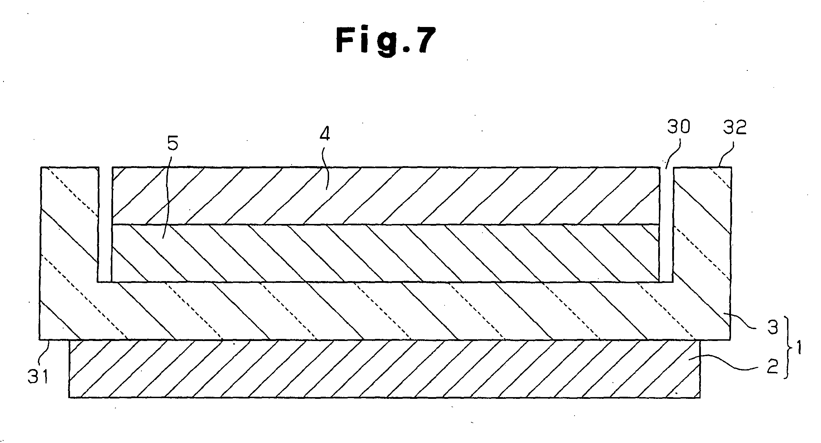

The liquid crystal display may include a plurality of the same kind or different kind of optical members. For example, as shown in Fig. 7, in a recess 30, the prism sheet 5 and the liquid crystal panel 4 may both be attached to the organic EL device.

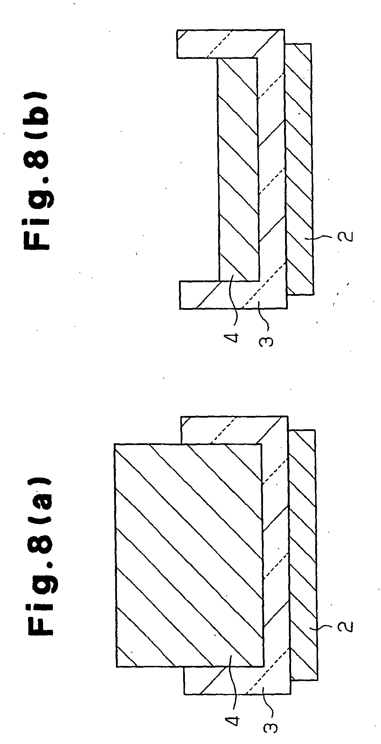

The depth of the recess 30 does not necessarily have to be the same as the thickness of the liquid crystal panel 4. For example, as shown in Fig. 8(a), in a liquid crystal display, the depth of the recess 30 may be less than the thickness of the liquid crystal panel 4. Alternatively, as shown in Fig. 8(b), in a liquid crystal display, the depth of the recess 30 may be greater than the thickness of the liquid crystal panel 4. In the former case, the liquid crystal panel 4 is partially accommodated in the recess 30. In the latter case, the liquid crystal panel 4 is completely accommodated in the recess 30.

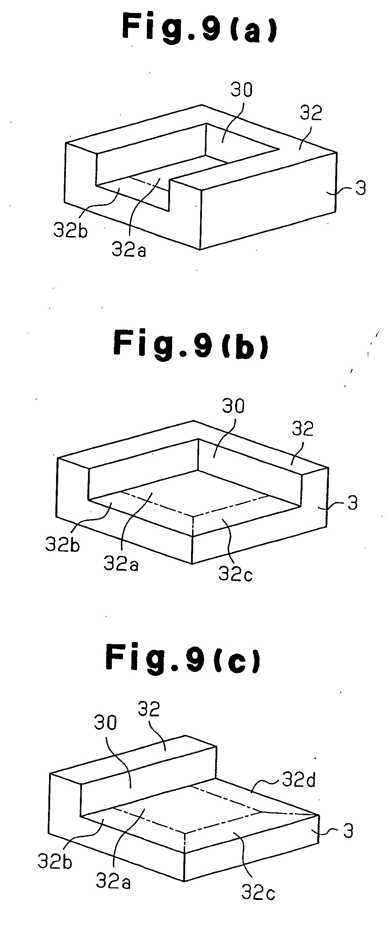

The rim of the transparent substrate 3 may partially have the same thickness as the central portion of the transparent substrate 3. For example, as shown in Fig. 9(a), the thickness of a portion 32b corresponding to one side of the transparent substrate 3 may be the same as the central portion 32a of the transparent substrate 3. As shown in Fig. 9(b), the thickness of two portions 32b and 32c corresponding to two sides of the transparent substrate 3 may be the same as the central portion of the transparent substrate 3. Alternatively, as shown in Fig. 9(c), the thickness of three portions 32b, 32c, and 32d corresponding to three sides of the transparent substrate 3 may be the same as the central portion 32a of the transparent substrate 3. In these variants, when attaching the liquid crystal panel 4 to the transparent substrate 3, the portion of the transparent substrate 3 at which the thickness differs from that of the central portion 32a of the transparent substrate 3 is used as a positioning guide. Therefore, these variants also have the same advantages as the above embodiment.

The recess 30 may be formed through processes other than sandblasting. For example, dry etching or wet etching may also be employed to form the recess 30. It is preferable that the bottom surface of the recess 30 be formed to have a rough surface even when performing a process other then sandblasting.

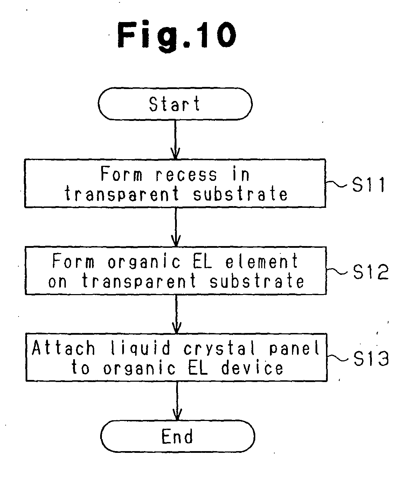

The organic EL element 2 may be formed on the transparent substrate 3 subsequent to the formation of the recess 30. In this case, the liquid crystal display is manufactured according to the procedures shown in the flowchart in Fig. 10. First, in step S11, the recess 30 is formed on a predetermined part of the transparent substrate 3. In step S12, the organic EL element 2 is formed on the surface of the transparent substrate 3 facing away from the recess 30 to complete the organic EL device 1. In the following step S13, the liquid crystal panel 4 is attached to the organic EL device 1 so that the liquid crystal panel 4 is accommodated within the recess 30. This completes the liquid crystal display. It is important that the depth of the recess 30 as well as the material of the transparent substrate 3 be such that when the transparent substrate 3 has the recess 30, the transparent substrate 3 is strong enough not to bend during formation of the organic EL element 2.

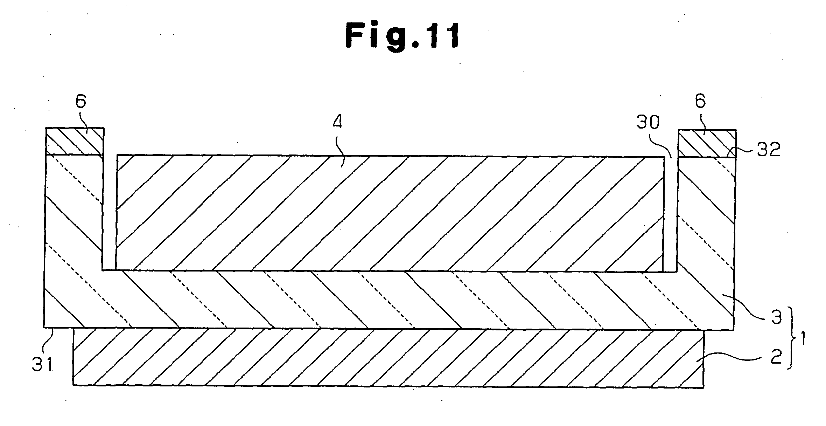

To prevent the light from exiting the light exit surface 32 from the portion corresponding to the rim of the transparent substrate 3, a light shield may be used to cover the rim. For example, as shown in the liquid crystal display of Fig. 11, a metal light reflector 6 may be arranged on the part of the light exit surface 32 corresponding to the rim of transparent substrate 3. The light shield arranged on the part of the light exit surface 32 may be the residual mask that was not removed after formation of the recess 30.

A light shield, such as a light reflector, may be arranged on the surface of the liquid crystal display, excluding the display surface 40.

A plurality of recesses 30 may be provided in the light exit surface 32.

It should be apparent to those skilled in the art that the present invention may be embodied in many other specific forms without departing from the spirit or scope of the invention. Therefore, the present invention is not to be limited to the details given herein, but may be modified within the scope and equivalence of the appended claims.

An area light emitting device includes a transparent or translucent substrate and an area light emitting element arranged on the substrate. The substrate includes a first surface facing the area light emitting element and a second surface facing away from the area light emitting element. The area light emitting element emits light that enters the first surface and exits from the second surface. The second surface includes a recess for accommodating an optical member that changes the characteristics of the light emitted from the area light emitting element.

## Claims

1. An area light emitting device for use with an optical member, the area light emitting device **characterized by**:
a transparent or translucent substrate; and
an area light emitting element arranged on the substrate; wherein:
the substrate includes a first surface facing the area light emitting element and a second surface facing away from the area light emitting element;
the area light emitting element emits light that enters the first surface and exits from the second surface; and
the second surface includes a recess for accommodating the optical member in which the optical member changes the characteristics of light emitted from the area light emitting element.

2. The area light emitting device as claimed in claim 1, **characterized in that** the recess is positioned substantially at the center of the second surface.

3. The area light emitting device as claimed in claim 1 or 2, **characterized in that** the recess is defined by a bottom surface and side surfaces surrounding the entire periphery of the bottom surface.

4. The area light emitting device as claimed in any one of claims 1 to 3, **characterized in that** the recess completely accommodates the entire optical member.

5. The area light emitting device as claimed in any one of claims 1 to 4, **characterized in that** the recess has a depth, and the optical member has a thickness, the depth of the recess being greater than the thickness of the optical member.

6. The area light emitting device as claimed in any one of claims 1 to 4, **characterized in that** the recess has a depth, and the optical member has a thickness, the depth of the recess being substantially the same as the thickness of the optical member.

7. The area light emitting device as claimed in any one of claims 1 to 6, **characterized in that** at least the bottom surface of the recess is a rough surface.

8. The area light emitting device as claimed in any one of claims 1 to 7, **characterized in that** the bottom surface of the recess has an arithmetic mean roughness Ra of 0.1µm to 10µm.

9. The area light emitting device as claimed in any one of claims 1 to 8, **characterized in that** the area light emitting element is an organic electroluminescence element.

10. An optical device **characterized by**:
the area light emitting device as claimed in any one of claims 1 to 9; and
the optical member accommodated in the recess.

11. The optical device as claimed in claim 10, **characterized in that** the recess completely accommodates the entire optical member.

12. A method for manufacturing an area light emitting device including a transparent or translucent substrate and an area light emitting element arranged on the transparent substrate for use with an optical member, the method **characterized by**:
preparing the substrate to include a first surface and a second surface, with the first surface and the second surface being located on opposite sides of the substrate;
forming the area light emitting element on the first surface of the substrate, wherein the area light emitting element emits light that enters the first surface and exits from the second surface; and
forming a recess in the second surface of the substrate after said forming of the area light emitting element,
wherein the recess is capable of accommodating the optical member in which the optical member changes the characteristics of light emitted from the area light emitting element.

13. The method as claimed in claim 12, **characterized in that** said forming a recess includes sandblasting the second surface of the substrate.

14. The method as claimed in claim 12, **characterized in that** said forming a recess includes:
covering the second surface, excluding the portion in which the recess is to be formed, with a mask; and
sandblasting the second surface in a state covered by the mask to form the recess in the portion of the second surface exposed from the mask.
